# EUROPEAN PATENT SPECIFICATION

(11) **EP 3 203 635 B1**
(45) Date of publication and mention of the grant of the patent: **09.05.2018**
(21) Application number: 16154369.9
(22) Date of filing: 05.02.2016
(51) Int. Cl.: H03L 7/06, H04L 27/26

(54) **CLOCK SYNCHRONIZER TO SYNCHRONIZE A DEVICE CLOCK WITH A CLOCK OF A REMOTE DEVICE**
UHRENSYNCHRONISIERUNGSEINRICHTUNG ZUR SYNCHRONISIERUNG EINER VORRICHTUNGSUHR MIT EINER UHR EINER ENTFERNTEN VORRICHTUNG
DISPOSITIF DE SYNCHRONISATION D'HORLOGE POUR SYNCHRONISER UNE HORLOGE DE DISPOSITIF AVEC UNE HORLOGE D'UN DISPOSITIF DISTANT

(43) Date of publication of application: 09.08.2017
(73) Proprietor: Panthronics AG, 8041 Graz (AT)
(72) Inventor: Crols, Jan, 3050 Oud-Heverlee (BE); Felicijan, Tomaz, 8020 Graz (AT); Jongsma, Jakob, 8042 Graz (AT); Pieber, Michael, 8062 Kumberg (AT); Nassar, Hamzeh, 8010 Graz (AT)
(74) Representative: Schwarz & Partner Patentanwälte OG

(56) References cited:
- EP-A2- 0 805 438
- WO-A1-2015/047280
- US-B1- 6 542 039

## Description

### FIELD OF THE INVENTION

The present invention relates to a device with an antenna that receives a target carrier signal from a remote target and transmits a device carrier signal modulated with data to communicate data between the device and the target, which device comprises clock extraction means to extract a target clock from the target carrier signal and driver means to generate the device carrier signal from a device clock and synchronization means to synchronize the frequency and phase of the device clock with the target clock.

The present invention relates to a method to synchronize the frequency and phase of a device clock within a device with a target clock of a remote target which target clock within the device is derived from a target carrier signal received from the target with an antenna of the device.

### BACKGROUND OF THE INVENTION

Wireless communication is used in a variety of fields and devices as for instance to identify products with a tag attached to the product or for a communication between a smart card and a reader or target for a payment application. Many such applications use standards like ISO/IEC18000-3 or ISO/IEC 14.443 Type A and B or ISO15.693 or ECMA-340 13,56 MHz Near Field Communication (NFC) that define protocols and types of modulation used to transmit information between the tag or smart card and the target. In most of these communications the target generates an electromagnetic field by sending a target carrier signal and the passive smart card or tag uses this electromagnetic field to generate power to start its internal processor and to initiate communication with the target using the electromagnetic field generated by the target.

NFC furthermore enables that a device (reader or target) simulates a smart card which actively sends data using its own electromagnetic field by sending a modulated device carrier signal. In such a case the device (reader or target that simulates a smart card) needs to synchronize or correct the frequency and phase of the device carrier signal with the target carrier signal to enable correct demodulation of the modulated data within the target.

EP 2 843 840 A1 discloses synchronization means to synchronize a device clock within the device with a reader clock of a remote reader which reader clock within the device is derived from the reader carrier signal received from the reader with an antenna of the device. These state of the art synchronization means comprise a first phase lock loop circuit that receives the reader carrier signal and generates a control signal. These synchronization means furthermore comprise a second phase lock loop circuit that receives a stable reference-oscillation signal and adjusts a fractional divider ratio according to the control signal of the first phase lock loop circuit to provide the device clock.

These synchronization means disclosed in EP 2 843 840 A1 comprise the disadvantage that it takes a relative long locking time until the device clock is synchronized to the reader or target clock. Disturbances during the locking time may influence the results negatively. It is furthermore a disadvantage of the known synchronization means that they need to run continuously what increases the power consumption of the device. US 6 542 039 B1 discloses a phase-locked loop apparatus which extends a capture range in clock reproduction when digital data is reproduced and performs a high-speed and stable phase locking.

### SUMMARY OF THE INVENTION

It is an objective of the invention to provide a device with synchronizations means and a method to synchronize the frequency and phase of a device clock within the device with a target clock of a remote target that needs only a short time to synchronize and reduces the power consumption of the device.

This objective is achieved with synchronization means that comprise:
time measurement means to measure the phase difference between the target clock and the device clock or an internal device clock related to the device clock to provide a phase information;
measurement control means to initiate a first time measurement that results in a first phase information and to initiate a second time measurement a fixed time period after the first time measurement that results in a second phase information;
frequency correction means to correct the frequency of the device clock and/ or the internal device clock to the frequency of the target clock based on an evaluation of the first phase information and second phase information by evaluation means;
which measurement control means are built to initiate a third time measurement after the frequency correction of the device clock and/or the internal device clock that results in a third phase information evaluated by the evaluation means and corrected by phase correction means which correct the phase of the device clock to the phase of the target clock.

This objective is furthermore achieved with a method that comprises the following steps:
measure the phase difference between the target clock and the device clock or an internal device clock related to the device clock and provide a first phase information;
count a fixed number of clocks of an internal clock to wait a fixed time;
measure the phase difference between the target clock and the device clock or the internal device clock again and provide a second phase information;
correct the frequency of the device clock and/or the internal device clock to the frequency of the target clock by evaluation of the first phase information and second phase information; measure the phase difference between the target clock and the device clock or the internal device clock again and provide a third phase information;
correct the phase of the device clock to the phase of the target clock by evaluation of the third phase information.

This provides the advantage that only three time measurements to measure phase differences are needed to correct the frequency and phase of the device clock to run synchronal to the frequency and phase of the target clock. This synchronization may be repeated after some time or if some errors are detected within the demodulated data received, but in principle this is a one time synchronization and not a continuous synchronization process like disclosed in prior art. As a result, power consumption within the device is reduced. Furthermore, all these time measurements are processed in the digital domain what increases the accuracy of the synchronization of the device carrier signal with the target carrier signal.

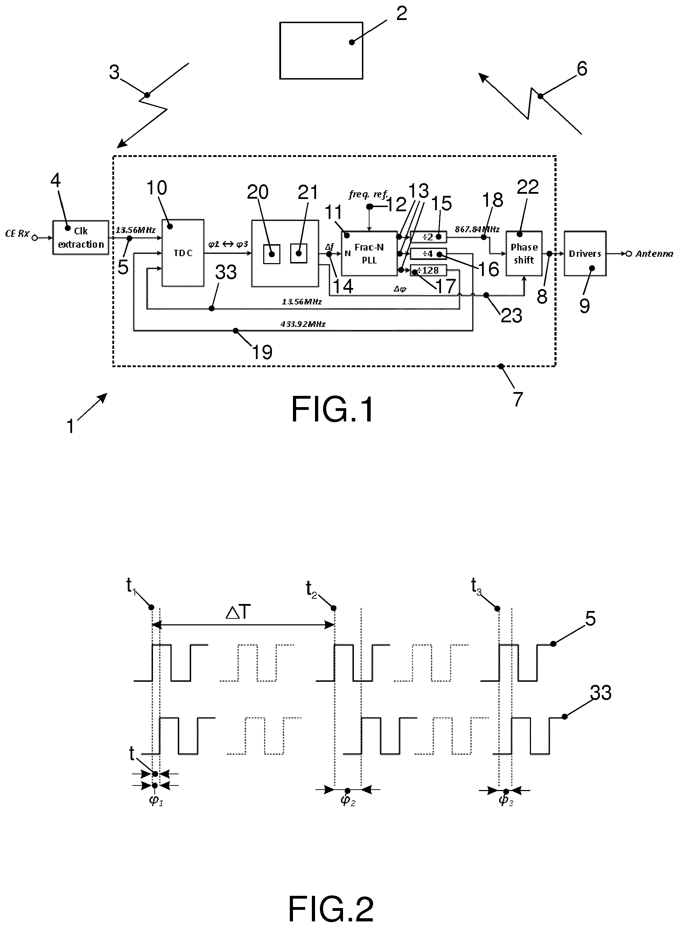

Different embodiments of the invention will be explained. In a simple embodiment there is no internal device clock used and all time measurements are done between the target clock and the device clock, which after synchronization both comprise the same frequency and phase. In another embodiment of the invention an internal device clock is used that may have the same frequency as the target clock or a multiple or split of the target clock, which internal device clock is used for the time measurements. In still another embodiment of the invention disclosed in Figures 1 to 4 below an internal device clock is used and the device clock after synchronization by the synchronization means comprises the same phase as the target clock, but its frequency is not identical with the frequency of the target clock. Synchronization of the frequency of the device clock with the target clock for this embodiment of the invention is meant in that way that the synchronized frequency is a fixed division or multiple of the target clock as will be explained below.

These and other aspects of the invention will be apparent from and elucidated with reference to the embodiments described hereinafter. The person skilled in the art will understand that various embodiments may be combined.

### BRIEF DESCRIPTION OF THE DRAWINGS

Figures 1 shows a device with synchronization means to synchronize a device clock with a target clock of a remote target.
Figure 2 shows a time diagram of the device clock and the target clock and phase information measured with time measurement means of the device shown in Figure 1.
Figure 3 shows details of the time measurement means of the device shown in Figure 1.
Figure 4 shows a time diagram of clocks and information generated in the device shown in Figure 1.

### DETAILED DESCRIPTION OF EMBODIMENTS

Figure 1 shows part of a device 1 that is in contactless communication with a target 2 based on ECMA-340 13,56 MHz Near Field Communication (NFC) Standard. Target 2 generates an electromagnetic field by sending a target carrier signal 3 with a frequency of 13,56MHz to communicate with passive smart cards or tags. Device 1 is an active element with its own power source, but simulates a smart card for particular NFC applications.

Device 1 comprises an antenna that receives the target carrier signal 3 from the remote target 2 and clock extraction means 4 to extract a target clock 5 from the target carrier signal 3. To comply with the NFC Standard, device 1 needs to transmit back a device carrier signal 6 with the same 13,56MHz frequency and phase as the target carrier signal 3, which device carrier signal 6 may be modulated with data to be transmitted from device 1 to target 2. Synchronization of the device carrier signal 6 to the target carrier signal 3 is needed to ensure error-free demodulation and decoding of data transmitted.

Device 1 comprises synchronization means 7 to synchronize the frequency and phase of a device clock 8 with the target clock 5. In the embodiment disclosed the frequency of the device clock 8 after synchronization is not the same or identical as the frequency of the target clock 5, but it is a defined multiple of the 13,56MHz and in that way synchronized. Elements of the synchronization means 7 and their functionality will be explained in detail based on the Figures 1 to 4. Device 1 furthermore comprises driver means 9 to generate the device carrier signal 6 from the device clock 8 that is related to an internal device clock 33 in that way that the frequency of device clock 8 is 867,84MHz and therefore 64 times higher than the frequency of internal device clock 33 with its 13,56MHz. Details of driver means 9 are disclosed in an earlier filed patent application about this power amplifier with the application number EP 15199768.1. Driver means 9 use the device clock 8 to generate the 13,56MHz that are synchronized with the same frequency and phase as the target clock 5. The device carrier signal 6 is used to drive the antenna of device 1 to generate the 13,56MHz electromagnetic field received in target 2.

Synchronization means 7 comprise time measurement means 10 to measure the phase difference or time difference between the target clock 5 and the internal device clock 33 and to provide a phase information *ϕ.* In this embodiment of the invention time measurement means 10 measure the time difference between the target clock 5 and the internal device clock 33. As shown in Figure 2 time measurement means 10 use the rising edge of the target clock 5 to start the time measurement and the rising edge of the next internal device clock 33 to stop the time measurement. The time measurement results in a measured time t that is equivalent to a phase information *ϕ* taking the frequency of 13,56MHz into account. As an example phase information *ϕ* = *45°* is equivalent to t = 9.22ns. In another embodiment of the invention time measurement means 10 could also use the rising edge of the internal device clock 33 to start the time measurement and the rising edge of the next target clock 5 to stop the time measurement to achieve a measured time t that comprises an equivalent phase information *ϕ.* In still another embodiment of the invention the device clock 8 would be provided to time measurement means 10 to measure the phase information *ϕ.*

Synchronization means 7 comprise frequency correction means 11 that receive a reference clock 12 from another part of device 1, not shown in Figure 1, which reference clock 12 comprises a frequency in the range of 9MHz to 52MHz. Frequency correction means 11 are realized by a phase lock loop element and provide a high frequency clock 13 of 1,736GHz corrected with a frequency error 14 to three dividers 15, 16 and 17 that divide the high frequency clock 13 into two internal clocks 18 and 19 and into the internal device clock 33, still without corrected phase, all with lower frequency than the high frequency clock 13. Time measurement means 10 use the internal clock 19 to measure the time difference between the target clock 5 and the internal device clock 33.

Synchronization means 7 furthermore comprise measurement control means 20 to initiate a first time measurement at time instance t₁, shown in Figure 2 left side, that results in a first phase information *ϕ₁* and to initiate a second time measurement at time instance t₂, shown in the middle of Figure 2, a fixed time period ΔT after the first time measurement that results in a second phase information *ϕ₂*. Synchronization means 7 furthermore comprise evaluation means 21 to evaluate the first phase information *ϕ₁* and the second phase information *ϕ₂* and to provide the frequency error 14 to the correction means 11 to correct the frequency of the internal device clock 33 to the frequency of the target clock 5. Evaluation means 21 are built to calculate the frequency error 14 between the target clock 5 and the internal device clock 33 using the formula: Δf=(ϕ₂ - ϕ₁)/ΔT. If for instance *ϕ₁* = *15°* and *ϕ₂* = *225°* with ΔT = 2.5ms this results in a frequency error of Δf= 233.3Hz. Frequency correction means 11 are built to correct the frequency of the internal device clock 33 to the frequency of the target clock 5 based on the calculated frequency error 14. This provides the advantage that synchronization means 7 synchronize the frequency of the internal device clock 33 and as a result also of device clock 8 with the target clock 5 with only two time measurements what can be done fast and with only minimal power consumption within device 1.

Measurement control means 20 are furthermore built to initiate a third time measurement at time instance t₃, shown in Figure 2 right side, after the frequency correction of the internal device clock 33 and of the device clock 8 what measurement results in a third phase information *ϕ₃*. Synchronization means 7 furthermore comprise phase correction means 22 to correct the phase of the device clock 8 to the phase of the target clock 5 with phase correction 23 evaluated based on the third phase information *ϕ₃*. This provides the advantage that synchronization means 7 synchronize the phase of the device clock 8 with the target clock 5 with only one time measurement what can be done fast and with only minimal power consumption within device 1.

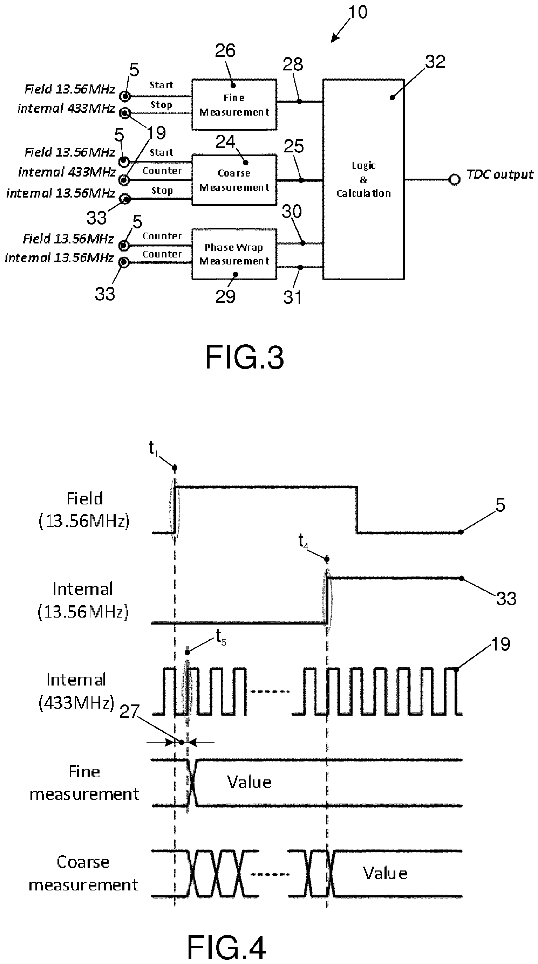

Figure 3 shows details of time measurement means 10 of the device 1 shown in Figure 1. Figure 4 shows a time diagram of clocks and information generated in the device 1 during time measurement with time measurement means 10. Time measurement means 10 comprise coarse measurement means 24 that start a counter that counts with the internal clock 19 at the edge of the target clock 5 at time instance t₁ and that stop the counter at the edge of the internal device clock 33 at time instance t₄ to provide coarse phase information 25. Time measurement means 10 furthermore comprise fine measurement means 26 that measure the time period 27 from the edge of the target clock 5 at time instance t₁ to the next edge of the internal clock 19 at time instance t₅ to provide fine phase information 28. With the frequency of 13,56MHz of the target clock 5 and the frequency of 433,92MHz of internal clock 19 fine measurement means 26 have a range of 73,74ns and a resolution of 0,1ns. In another embodiment of the invention the range could be e.g. 5ns with the same resolution of 0,1ns. Time measurement means 10 are built to evaluate the coarse phase information 25 and the fine phase information 28 to provide the phase information *ϕ.* This provides the advantage that time measurement means 10 measures the phase difference very accurate and fast.

Time measurement means 10 furthermore comprise a phase wrap detector 29 that counts the number of edges of the target clock 5 and the number of edges of the internal device clock 33 during the fixed time period ΔT and provides a phase wrap information that comprises a number information 30 of the counted edges of the target clock 5 and a number information 31 of the counted edges of the internal device clock 33. Calculation means 32 of time measurement means 10 compare this number information 30 and 31 and detect a phase wrap. A phase wrap happens if the frequencies of the target clock 5 and the internal device clock 33 are far off and a full period or even several full periods of the clocks have to be taken into account for the evaluation of the measured phase difference. This provides the advantage that time measurement means 10 detect phase wraps and even in such cases evaluate the correct phase information to be used to synchronize the device clock 8 with target clock 5.

It has to be stated that in the embodiment provided time measure means 10 do not use the final synchronized device clock 8 as input to measure the phase difference to the target clock 5 as they use the internal device clock 33 before phase correction processed by phase correction means 22. This is possible as there is no difference for the frequency correction and the phase correction. Using the uncorrected internal device clock 33 for third time measurement will result in the measurement of that uncorrected phase error which will be corrected by phase correction means 22. In another embodiment of the invention device clock 8 could be used for the third time meansurement as well.

Device 1 furthermore uses a method to synchronize the frequency and phase of the device clock 8 within the device 1 with the target clock 5 of the remote target 2, which target clock 5 within the device 1 is derived from the target carrier signal 3 received from the target 2 with an antenna of the device 1. This method comprises the following steps:
measure the phase difference between the target clock 5 and the device clock or the internal device clock 33 and provide a first phase information *ϕ₁*;
count a fixed number of clocks of an internal clock to wait a fixed time;
measure the phase difference between the target clock 5 and the device clock or the internal device clock 33 again and provide a second phase information *ϕ₂*;
correct the frequency of the device clock 8 and/or the internal device clock 33 to the frequency of the target clock 5 by evaluation of the first phase information *ϕ₁* and second phase information *ϕ₂*;
measure the phase difference between the target clock 5 and the device clock 8 or internal device clock 33 again and provide a third phase information *ϕ₃*;
correct the phase of the device clock 8 to the phase of the target clock 5 by evaluation of the third phase information *ϕ₃*. This method provides the advantages described above in relation with the device 1.

A device with inventive synchronizaton means has been described based on an embodiment that complies to the NFC Standard and with a device 1 that simulates a smart card or tag and actively sends data modulated onto a device carrier signal. The inventive concept of synchronization means as describe may be used within any other device that needs to synchronize its clock to the clock of a remote further device. Such concept could also be adopted for other fileds including systems that detect movement, location and proximity. Where no second device exists, and the incoming signal is a reflection of the systems own signal, like in radar or motion sensors.

In another embodiment of the invention time measurement means 10 only require fine measurement means 26 to provide phase information ϕ. This enables a simple solution for time measurement means.

In another embodiment of the invention both the internal device clock and the device clock could be identical and run on a frequency of 13,56MHz, what means that internal device clock is not needed anymore as separat clock. Synchronizaton means would in that case synchronize and generate a device clock with exact the same frequency and phase as the traget clock and feed this device clock into driver means that directly would use this device clock to generate the device carrier signal.

## Claims

1. Device (1) with an antenna that receives a target carrier signal (3) from a remote target (2) and transmits a device carrier signal (6) modulated with data to communicate data between the device (1) and the target (2), which device (1) comprises:
clock extraction means (4) to extract a target clock (5) from the target carrier signal (3);
driver means (9) to generate the device carrier signal (6) from a device clock (8);
synchronization means (7) to synchronize the frequency and phase of the device clock (8) with the target clock (5),
**characterized in that** the synchronization means (7) comprise:
time measurement means (10) to measure the phase difference between the target clock (5) and the device clock (8) or an internal device clock (33) related to the device clock (8) and to provide a phase information (*ϕ₁*,*ϕ₂*,*ϕ₃*);
measurement control means (20) to initiate a first time measurement that results in a first phase information (*ϕ₁*) and to initiate a second time measurement a fixed time period (ΔT) after the first time measurement that results in a second phase information (*ϕ₂*);
frequency correction means (11) to correct the frequency of the device clock (8) and/or the internal device clock (33) to the frequency of the target clock (5) based on an evaluation of the first phase information (*ϕ₁*) and second phase information (*ϕ₂*) by evaluation means (21);
which measurement control means (20) are built to initiate a third time measurement after the frequency correction of the device clock (8) and/or the internal device clock (33) that results in a third phase information (*ϕ₃*) evaluated by the evaluation means (21) and corrected by phase correction means (22) which correct the phase of the device clock (8) to the phase of the target clock (5).

2. Device (1) according to claim 1, which comprises clock generation means to generate a an internal clock (19) with a higher frequency than the frequency of the target clock (5) and wherein the time measurement means (10) comprise coarse measurement means (24) that start a counter that counts with the internal clock (19) at an edge of the target clock (5) or of the internal device clock (33) and that stop the counter at the an edge of the internal device clock (33) or the target clock (5) to provide a coarse phase information (25).

3. Device (1) according to claim 2, wherein the time measurement means (10) comprise fine measurement means (26) that measure the time (27) from an edge of the target clock (5) to the next edge of the internal clock (19) to provide a fine phase information (28).

4. Device (1) according to claim 3, wherein the time measurement means (10) are built to evaluate the coarse phase information (25) and the fine phase information (28) to provide the phase information (*ϕ₁*, *ϕ₂*, *ϕ₃*).

5. Device (1) according to claim 4, wherein the time measurement means (10) comprise a phase wrap detector (29) that counts the number of edges of the target clock (5) and the number of edges of the internal device clock (33) during the fixed time period (ΔT) and provides a phase wrap information (30, 31).

6. Device (1) according to claim 5, wherein the time measurement means (10) are built to evaluate the phase wrap information (30, 31) to provide the phase information (*ϕ₁*, *ϕ₂*, *ϕ₃*).

7. Device (1) according to any of the claims 1 to 6, wherein the evaluation means (21) are built to calculate a frequency error (14) between the target clock (5) and the device clock (8) or the internal device clock (33) using the formula: Δf = (ϕ₂ - ϕ₁)/ΔT with ϕ₁ as first phase information and ϕ₂ as second phase information and ΔT as fixed time period and which frequency correction means (11) are furthermore built to correct the frequency of the device clock (8) and/or the internal device clock (33) to the frequency of the target clock (5) based on the calculated frequency error (14).

8. Device (1) according to any of the claims 1 to 7, wherein the device (1) simulates a smart card or tag with active data transmission.

9. Method to synchronize the frequency and phase of a device clock (8) within a device (1) with a target clock (5) of a remote target (2) which target clock (5) within the device (1) is derived from a target carrier signal (3) received from the target (2) with an antenna of the device (1), which method comprises the following steps:
measure the phase difference between the target clock (5) and the device clock (8) or an internal device clock (33) related to the device clock (8) and provide a first phase information (*ϕ₁*);
count a fixed number of clocks of an internal clock to wait a fixed time;
measure the phase difference between the target clock (5) and the device clock (8) or the internal device clock (33) again and provide a second phase information (*ϕ₂*);
correct the frequency of the device clock (8) and/or the internal device clock (33) to the frequency of the target clock (5) by evaluation of the first phase information (*ϕ₁*) and second phase information (*ϕ₂*);
measure the phase difference between the target clock (5) and the device clock (8) internal device clock (33) again and provide a third phase information (*ϕ₃*);
correct the phase of the device clock (8) to the phase of the target clock (5) by evaluation of the third phase information (*ϕ₃*).

10. Method according to claim 9, wherein the measurement of the phase difference between the target clock (5) and the internal device clock (33) is done with the following steps:
start a counter that counts with the internal clock (19) at an edge of the target clock (5) or of the internal device clock (33) and stop the counter at an edge of the internal device clock (33) or target clock (5) to provide a coarse phase information (25);
measure the time period (27) from an edge of the target clock (5) to the next edge of the internal device clock (33) to provide a fine phase information (28);
count the number of edges of the target clock (5) and the number of edges of the internal device clock (33) during the fixed time period (ΔT) and provide a phase wrap information (30, 31);
evaluate the coarse phase information (25) and the fine phase information (28) and the phase wrap information (30, 31) to provide the phase information (*ϕ₁*, *ϕ₂*, *ϕ₃*).

## Patentansprüche

1. Vorrichtung (1) mit einer Antenne, die ein Zielträgersignal (3) von einem entfernten Ziel (2) empfängt und ein Vorrichtungsträgersignal (6) sendet, das mit Daten moduliert ist, um Daten zwischen der Vorrichtung (1) und dem Ziel (2) zu kommunizieren, wobei die Vorrichtung (1) umfasst:
Taktextraktionsmittel (4), um einen Zieltakt (5) vom Zielträgersignal (3) zu extrahieren;
Treibermittel (9), um das Vorrichtungsträgersignal (6) von einem Vorrichtungstakt (8) zu erzeugen;
Synchronisierungsmittel (7), um die Frequenz und Phase des Vorrichtungstakts (8) mit dem Zieltakt (5) zu synchronisieren,
**dadurch gekennzeichnet, dass** die Synchronisierungsmittel (7) umfassen:
Zeitmessungsmittel (10), um die Phasendifferenz zwischen dem Zieltakt (5) und dem Vorrichtungstakt (8) oder einem mit dem Vorrichtungstakt (8) zusammenhängenden internen Vorrichtungstakt (33) zu messen und eine Phaseninformation (*ϕ₁, ϕ₂, ϕ₃*) bereitzustellen;
Messungssteuermittel (20), um eine erste Zeitmessung zu initiieren, die in einer ersten Phaseninformation (*ϕ₁*) resultiert, und eine zweite Zeitmessung eine feststehende Zeitdauer (ΔT) nach der ersten Zeitmessung zu initiieren, die in einer zweiten Phaseninformation (*ϕ₂*) resultiert;
Frequenzkorrekturmittel (11), um die Frequenz des Vorrichtungstakts (8) und/oder des internen Vorrichtungstakts (33) auf die Frequenz des Zieltakts (5) basierend auf einer Evaluierung der ersten Phaseninformation (*ϕ₁*) und der zweiten Phaseninformation (*ϕ₂*) durch Evaluierungsmittel (21) zu korrigieren; wobei die Messungssteuermittel (20) dazu gebaut sind, eine dritte Zeitmessung nach der Frequenzkorrektur des Vorrichtungstakts (8) und/oder des internen Vorrichtungstakts (33) zu initiieren, was in einer dritten Phaseninformation (*ϕ₃*) resultiert, die von den Evaluierungsmitteln (21) evaluiert und den Phasenkorrekturmitteln (22) korrigiert wird, welche die Phase des Vorrichtungstakts (8) auf die Phase des Zieltakts (5) korrigieren.

2. Vorrichtung (1) gemäß Anspruch 1, welche Takterzeugungsmittel umfasst, um einen internen Takt (19) mit einer höheren Frequenz als der Frequenz des Zieltakts (5) zu erzeugen, und wobei die Zeitmessungsmittel (10) Grobmessungsmittel (24) umfassen, die einen Zähler starten, der mit dem internen Takt (19) an einer Flanke des Zieltakts (5) oder des internen Vorrichtungstakts (33) zählt, und den Zähler an einer Flanke des internen Vorrichtungstakts (33) oder des Zieltakts (5) stoppen, um eine grobe Phaseninformation (25) bereitzustellen.

3. Vorrichtung (1) gemäß Anspruch 2, wobei die Zeitmessungsmittel (10) Feinmessungsmittel (26) umfassen, welche die Zeit (27) von einer Flanke des Zieltakts (5) bis zur nächsten Flanke des internen Takts (19) messen, um eine feine Phaseninformation (28) bereitzustellen.

4. Vorrichtung (1) gemäß Anspruch 3, wobei die Zeitmessungsmittel (10) dazu gebaut sind, die grobe Phaseninformation (25) und die feine Phaseninformation (28) zu evaluieren, um die Phaseninformation (*ϕ₁, ϕ₂, ϕ₃*) bereitzustellen.

5. Vorrichtung (1) gemäß Anspruch 4, wobei die Zeitmessungsmittel (10) einen Phasen-Wrap-Detektor (29) umfassen, der die Anzahl an Flanken des Zieltakts (5) und die Anzahl an Flanken des internen Vorrichtungstakts (33) während der feststehenden Zeitdauer (ΔT) zählt und eine Phasen-Wrap-Information (30, 31) bereitstellt.

6. Vorrichtung (1) gemäß Anspruch 5, wobei die Zeitmessungsmittel (10) dazu gebaut sind, die Phasen-Wrap-Information (30, 31) zu evaluieren, um die Phaseninformation (*ϕ₁, ϕ₂, ϕ₃*) bereitzustellen.

7. Vorrichtung (1) gemäß einem der Ansprüche 1 bis 6, wobei die Evaluierungsmittel (21) dazu gebaut sind, einen Frequenzfehler (14) zwischen dem Zieltakt (5) und dem Vorrichtungstakt (8) oder dem internen Vorrichtungstakt (33) unter Verwendung der Formel: Δf = (*ϕ₂-ϕ₁*) / ΔT zu berechnen, wobei *ϕ₁* als erste Phaseninformation und *ϕ₂* als zweite Phaseninformation und ΔT als feststehende Zeitdauer verwendet werden, und wobei die Frequenzkorrekturmittel (11) darüber hinaus dazu gebaut sind, die Frequenz des Vorrichtungstakts (8) und/oder des internen Vorrichtungstakts (33) auf die Frequenz des Zieltakts (5) basierend auf dem berechneten Frequenzfehler (14) zu korrigieren.

8. Vorrichtung (1) gemäß einem der Ansprüche 1 bis 7, wobei die Vorrichtung (1) eine Smart-Card oder ein Tag mit aktiver Datenübertragung simuliert.

9. Verfahren zum Synchronisieren der Frequenz und der Phase eines Vorrichtungstakts (8) innerhalb einer Vorrichtung (1) mit einem Zieltakt (5) eines entfernten Ziels (2), wobei der Zieltakt (5) innerhalb der Vorrichtung (1) von einem Zielträgersignal (3) stammt, das vom Ziel (2) mit einer Antenne der Vorrichtung (1) empfangen wird, wobei das Verfahren die folgenden Schritte umfasst:
Messen der Phasendifferenz zwischen dem Zieltakt (5) und dem Vorrichtungstakt (8) oder einem internen Vorrichtungstakt (33), der mit dem Vorrichtungstakt (8) zusammenhängt, und Bereitstellen einer ersten Phaseninformation (*ϕ*);
Zählen einer feststehenden Anzahl von Takten eines internen Takts, um eine feststehende Zeitdauer zu warten;
Erneutes Messen der Phasendifferenz zwischen dem Zieltakt (5) und dem Vorrichtungstakt (8) oder dem internen Vorrichtungstakt (33) und Bereitstellen einer zweiten Phaseninformation (*ϕ*₂);
Korrigieren der Frequenz des Vorrichtungstakts (8) und/oder des internen Vorrichtungstakts (33) auf die Frequenz des Zieltakts (5) durch Evaluieren der ersten Phaseninformation (*ϕ₁*) und der zweiten Phaseninformation (*ϕ*₂);
Erneutes Messen der Phasendifferenz zwischen dem Zieltakt (5) und dem Vorrichtungstakt (8) und dem internen Vorrichtungstakt (33) und Bereitstellen einer dritten Phaseninformation (*ϕ₃*);
Korrigieren der Phase des Vorrichtungstakts (8) auf die Phase des Zieltakts (5) durch Evaluieren der dritten Phaseninformation (*ϕ₃*).

10. Verfahren gemäß Anspruch 9, wobei die Messung der Phasendifferenz zwischen dem Zieltakt (5) und dem internen Vorrichtungstakt (33) über die folgenden Schritte erfolgt:
Starten eines Zählers, der mit dem internen Takt (19) an einer Flanke des Zieltakts (5) oder des internen Vorrichtungstakts (33) zählt, und Stoppen des Zählers an einer Flanke des internen Vorrichtungstakts (33) oder Zieltakts (5), um eine grobe Phaseninformation (25) bereitzustellen;
Messen der Zeitdauer (27) von einer Flanke des Zieltakts (5) zur nächsten Flanke des internen Vorrichtungstakts (33), um eine feine Phaseninformation (28) bereitzustellen;
Zählen der Anzahl an Flanken des Zieltakts (5) und der Anzahl an Kanten des internen Vorrichtungstakts (33) während der feststehenden Zeitdauer (ΔT) und Bereitstellen einer Phasen-Wrap-Information (30, 31),
Evaluieren der groben Phaseninformation (25) und der feinen Phaseninformation (28) und der Phasen-Wrap-Information (30, 31), um die Phaseninformation (*ϕ₁, ϕ₂, ϕ₃*) bereitzustellen.

## Revendications

1. Dispositif (1) doté d'une antenne qui reçoit un signal de porteuse cible (3) d'une cible distante (2) et qui transmet un signal (6) de porteuse du dispositif modulé avec des données pour communiquer des données entre le dispositif (1) et la cible (2), ledit dispositif (1) comprenant :
un moyen d'extraction (4) d'une horloge pour extraire une horloge cible (5) du signal de porteuse cible (3) ;
un moyen de pilotage (9) pour générer le signal de porteuse (6) du dispositif à partir d'une horloge (8) du dispositif ;
des moyens de synchronisation (7) pour synchroniser la fréquence et la phase de l'horloge (8) du dispositif avec l'horloge cible (5) ;
**caractérisé en ce que** les moyens de synchronisation (7) comprennent :
des moyens de mesure temporelle (10) pour mesurer la différence de phase entre l'horloge cible (5) et l'horloge (8) du dispositif ou une horloge interne (33) du dispositif associée à l'horloge (8) du dispositif et pour fournir des informations de phase (ϕ₁, ϕ₂, ϕ₃) ;
des moyens de commande de mesure (20) pour initier une première mesure temporelle qui donne des premières informations de phase (ϕ₁) et pour initier une deuxième mesure temporelle d'une période de temps fixe (ΔT) suivant la première mesure temporelle qui donne des deuxièmes informations de phase (ϕ2) ;
des moyens de correction de fréquence (11) pour corriger la fréquence de l'horloge (8) du dispositif et/ou de l'horloge interne(33) du dispositif par rapport à la fréquence de l'horloge cible (5) sur la base d'une évaluation des premières informations de phase (ϕ₁) et des deuxièmes informations de phase (ϕ₂) par des moyens d'évaluation (21) ;
lesdits moyens de commande de mesure (20) sont conçus pour initier une troisième mesure temporelle à la suite de la correction de fréquence de l'horloge (8) du dispositif et/ou de l'horloge interne (33) du dispositif qui donne des troisièmes informations de phase (ϕ3) évaluées par les moyens d'évaluation (21) et corrigées par des moyens de correction de phase (22) qui corrigent la phase de l'horloge (8) du dispositif par rapport à la phase de l'horloge cible (5).

2. Dispositif (1) selon la revendication 1, qui comprend un moyen de génération d'horloge pour générer une horloge interne (19) ayant une fréquence plus élevée que la fréquence de l'horloge cible (5) et dans lequel les moyens de mesure temporelle (10) comprennent des moyens de mesure grossière (24) qui démarrent un compteur qui assure un comptage à l'aide de l'horloge interne (19) au niveau d'un front de l'horloge cible (5) ou de l'horloge interne (33) du dispositif et qui arrête le compteur au niveau d'un front de l'horloge interne (33) du dispositif ou de l'horloge cible (5) pour fournir des informations grossières de phase (25).

3. Dispositif (1) selon la revendication 2, dans lequel les moyens de mesure temporelle (10) comprennent un moyen de mesure fine (26) qui mesure le temps (27) d'un front de l'horloge cible (5) au front suivant de l'horloge interne (19) de façon à fournir des informations fines de phase (28).

4. Dispositif (1) selon la revendication 3, dans lequel les moyens de mesure temporelle (10) sont conçus pour évaluer les informations grossières de phase (25) et les informations fines de phase (28) de façon à fournir les informations de phase (ϕ₁, ϕ₂, ϕ₃).

5. Dispositif (1) selon la revendication 4, dans lequel les moyens de mesure temporelle (10) comprennent un détecteur de bouclage de phase (29) qui compte le nombre de fronts de l'horloge cible (5) et le nombre de fronts de l'horloge interne (33) du dispositif pendant la période de temps fixe (ΔT) et qui fournit des informations de bouclage de phase (30, 31).

6. Dispositif (1) selon la revendication 5, dans lequel les moyens de mesure temporelle (10) sont conçus pour évaluer les informations de bouclage de phase (30, 31) de façon à fournir les informations de phase (ϕ₁, ϕ₂, ϕ₃).

7. Dispositif (1) selon l'une quelconque des revendications 1 à 6, dans lequel les moyens d'évaluation (21) sont conçus pour calculer une erreur de fréquence (14) entre l'horloge cible (5) et l'horloge (8) du dispositif ou l'horloge interne (33) du dispositif au moyen de la formule : Δf = (ϕ₂ - ϕ₁)/ΔT, ϕ₁ étant des premières informations de phase et ϕ₂ étant des deuxièmes informations de phase et ΔT étant de période de temps fixe, et lesdits moyen de correction de fréquence (11) étant en outre conçus pour corriger la fréquence de l'horloge (8) du dispositif et/ou de l'horloge interne (33) du dispositif par rapport à la fréquence de l'horloge cible (5) sur la base de l'erreur de fréquence calculée (14).

8. Dispositif (1) selon l'une quelconque des revendications 1 à 7, dans lequel le dispositif (1) simule une carte à puce ou une étiquette intelligente avec une transmission de données active.

9. Procédé pour synchroniser la fréquence et la phase d'une horloge (8) du dispositif à l'intérieur d'un dispositif (1) avec une horloge cible (5) d'une cible distante (2), ladite horloge cible (5) à l'intérieur du dispositif (1) étant dérivée d'un signal de porteuse cible (3) reçu de la cible (2) au moyen d'une antenne du dispositif (1), ledit procédé comprenant les étapes suivantes :
mesurer la différence de phase entre l'horloge cible (5) et l'horloge (8) du dispositif ou une horloge interne (33) du dispositif associée à l'horloge (8) du dispositif et fournir des premières informations de phase (ϕ₁) ;
compter un nombre fixe d'horloges d'une horloge interne de façon à attendre un temps fixe ;
mesurer de nouveau la différence de phase entre l'horloge cible (5) et l'horloge (8) du dispositif ou l'horloge interne (33) du dispositif et fournir des deuxièmes informations de phase (ϕ₂) ;
corriger la fréquence de l'horloge (8) du dispositif et/ou de l'horloge interne (33) du dispositif par rapport à la fréquence de l'horloge cible (5) par une évaluation des premières informations de phase (ϕ₁) et des deuxièmes informations de phase (ϕ₂) ;
mesurer de nouveau la différence de phase entre l'horloge cible (5) et l'horloge (8) du dispositif ou l'horloge interne(33) du dispositif et fournir des troisièmes informations de phase (ϕ₃) ;
corriger la phase de l'horloge (8) du dispositif par rapport à la phase de l'horloge cible (5) par une évaluation des troisièmes informations de phase (ϕ₃).

10. Procédé selon la revendication 9, dans lequel la mesure de la différence de phase entre l'horloge cible (5) et l'horloge interne (33) du dispositif se fait selon les étapes suivantes:
démarrer un compteur qui assure un comptage, à l'aide de l'horloge interne (19), au niveau d'un front de l'horloge cible (5) ou de l'horloge interne (33) du dispositif interne, et arrêter le compteur au niveau d'un front de l'horloge (33) du dispositif ou de l'horloge cible (5) de façon à fournir des informations grossières de phase (25) ;
mesurer la période de temps (27) d'un front de l'horloge cible(5) au front suivant de l'horloge (33) du dispositif de façon à fournir des informations fines de phase (28) ;
compter le nombre de fronts de l'horloge cible (5) et le nombre de fronts de l'horloge interne (33) du dispositif pendant la période de temps fixe (ΔT) et fournir des informations de bouclage de phase (30, 31) ;
évaluer les informations grossières de phase (25) et les informations fines de phase (28) ainsi que les informations de bouclage de phase (30, 31) pour fournir les informations de phase (ϕ₁, ϕ₂, ϕ₃).
